# EUROPÄISCHE PATENTSCHRIFT

(11) **EP 3 252 549 B1**
(45) Veröffentlichungstag und Bekanntmachung des Hinweises auf die Patenterteilung: **24.06.2020**
(21) Anmeldenummer: 16172128.7
(22) Anmeldetag: 31.05.2016
(51) Int. Cl.: G05B 19/042

(54) **VERFAHREN ZUM BETREIBEN EINER AUTOMATISIERUNGSEINRICHTUNG SOWIE AUTOMATISIERUNGSEINRICHTUNG**
METHOD FOR OPERATING AN AUTOMATION DEVICE AND AUTOMATION DEVICE
PROCÉDÉ DE FONCTIONNEMENT D'UN DISPOSITIF D'AUTOMATISATION ET PROCÉDÉ D'AUTOMATISATION

(43) Veröffentlichungstag der Anmeldung: 06.12.2017
(73) Patentinhaber: Siemens Aktiengesellschaft, 80333 München (DE)
(72) Erfinder: Lutz, Benjamin, 76327 Pfinztal (DE); Wolf, Gerrit, 76187 Karlsruhe (DE)

(56) Entgegenhaltungen:
- US-A1- 2015 316 904
- Hörnicke M. ET AL.: "Vollständiger Test des Automatisierungssystems - Domänenübergreifende Integration heterogener Hardware-Emulatoren in einem virtuellen Framework", Conference: Automation 2012, 30. Juni 2012 (2012-06-30), Seiten 1-15, XP55318407, Gefunden im Internet: URL:http://acer-/common/downloadOriginal.d o [gefunden am 2016-11-10]

## Beschreibung

Die Erfindung betrifft ein Verfahren zum Betreiben einer Automatisierungseinrichtung, die mindestens ein reales Automatisierungsgerät zum Steuern eines technischen Prozesses, eine Operator-Station zum Bedienen und Beobachten des zu steuernden technischen Prozesses, ein Engineering-System und virtuelle Automatisierungsgeräte umfasst, die jeweils Funktionen eines realen Automatisierungsgerätes nachbilden und die auf einem Server hinterlegt sind. Ferner betrifft die Erfindung eine Automatisierungseinrichtung zur Durchführung des Verfahrens.

In der Automatisierungstechnik werden immer häufiger Simulationen eingesetzt, die zum Testen von Steuerprogrammen für Automatisierungsgeräte (speicherprogrammierbare Steuerungen, PLCs), zur virtuellen Inbetriebnahme oder zur Migration von Automatisierungskomponenten vorgesehen sind. Dazu werden gewöhnlich sowohl die Automatisierungskomponenten als auch Prozesse modelliert und virtuell auf Rechnern bzw. Servern betrieben.

Um aus einer solchen Simulation jedoch auch für die realen Automatisierungskomponenten Rückschlüsse ziehen zu können, sind gewisse Randbedingungen zu beachten, die eine derartige Simulation erfüllen muss. So ist es im Rahmen der Automatisierungstechnik von Bedeutung, dass das Verhalten im Hinblick auf Echtzeit sowie Deterministik der Ergebnisse mit den realen Automatisierungskomponenten der Automatisierungseinrichtung übereinstimmen. Wenn alle Automatisierungskomponenten (Steuerungen, dezentrale Peripherien, I/O-Module, Aktuatoren, Sensoren, Kommunikationsmodule und Prozesse) virtuell ausgebildet sind, ist es ohne Weiteres möglich, das Echtzeitverhalten in gewisser Weise zu entkoppeln und die Simulation der virtuellen Automatisierungskomponenten "einzubremsen", um die Deterministik zu gewährleisten. Im Rahmen von Mischkonfigurationen, d. h. in Automatisierungseinrichtungen, die sowohl reale als auch virtuelle Automatisierungskomponenten bzw. Simulations-Automatisierungsgeräte umfassen, sind Echtzeitverletzung nicht zulässig, weil die realen Automatisierungskomponenten umgehend aufgrund einer erkannten Zykluszeitverletzung bzw. Echtzeitverletzung gestört sind und einen Fehler melden. Eine störungsfreie Inbetriebnahme der Automatisierungseinrichtung, in der sukzessive virtuelle Automatisierungsgeräte in Betrieb genommen werden, bevor diese nach einer im Ergebnis zufriedenstellenden Simulation durch reale Automatisierungsgeräte ersetzt werden, ist aufgrund dieses fehlerhaften Echtzeitverhaltens der virtuellen Komponenten nicht möglich.

Aus der US 2015/0316904 A1 ist ein mit realen und virtuellen Komponenten versehenes industrielles Steuerungssystem bekannt.

Der Erfindung liegt die Aufgabe zugrunde, ein Verfahren der eingangs genannten Art anzugeben, welches insbesondere die Inbetriebnahme der Automatisierungseinrichtung vereinfacht. Darüber hinaus ist eine Automatisierungseinrichtung zu schaffen, welche zur Durchführung des Verfahrens geeignet ist.

Diese Aufgabe wird im Hinblick auf das Verfahren durch die im Anspruch 1 angegebenen, bezüglich der Automatisierungseinrichtung durch die im Anspruch 3 angegebenen Maßnahmen gelöst.

Vorteilhaft ist, dass durch eine geeignete Verteilung der virtuellen Steuerungen bzw. virtuellen Automatisierungsgeräte (Simulations-Automatisierungsgeräte) auf Servern das Echtzeitverhalten der Automatisierungseinrichtung weitgehend ermöglicht wird, wobei darüber hinaus eine kostenoptimale "Simulationsverteilung" sichergestellt wird. Es muss lediglich die Hardware (Server, Rechner) bereitgestellt werden, die für diese "Simulationsverteilung" benötigt wird. Ferner wird durch das Echtzeitverhalten bzw. durch die Echtzeitfähigkeit der Automatisierungseinrichtung weitgehend sichergestellt, dass durch den späteren Einsatz realer Automatisierungsgeräte anstelle der virtuellen Automatisierungsgeräte die Produktion störungsfrei gestartet werden kann.

Der Erfindung liegt die Idee zu Grunde, die Auslastung (Rechenlast) bzw. Belastung des Servers zu ermitteln, indem die Auslastung bzw. Belastung der virtuellen Automatisierungsgeräte (Simulations-Automatisierungsgerät) erfasst wird. Für den Fall, dass die Auslastung bzw. Belastung einen Schwellwert erreicht oder überschreitet, erfolgt eine Auslagerung des oder der virtuellen Automatisierungsgeräte auf einen weiteren oder auf mehrere weitere Server. Dabei wird der Schwellwert so gewählt, dass das Echtzeitverhalten der Automatisierungseinrichtung gewährleitet ist. Jedes Automatisierungsgerät sowie jedes virtuelle Automatisierungsgerät weist Systemfunktionen auf, wobei mittels eines Engineering-Systems und mittels einer dieser Systemfunktionen - im Folgenden als Monitoring und Control-Systemfunktion bezeichnet - Prozessobjekte konfiguriert sowie ggf. parametriert werden und ferner mittels dieser Monitoring und Control-Systemfunktion die anderen Systemfunktionen im Hinblick auf eine Auslastung des jeweiligen Automatisierungsgerätes und des jeweiligen virtuellen Automatisierungsgerätes überwacht werden.

Eine erste konfigurierte Anzahl der Prozessobjekte repräsentiert die Belastung (Rechenlast) des jeweiligen Automatisierungsgerätes und des jeweiligen virtuellen Automatisierungsgerätes im Hinblick auf die Prozesssteuerung, eine zweite konfigurierte Anzahl der Prozessobjekte repräsentiert die Belastung dieser Geräte bezüglich der Kommunikation zwischen den Automatisierungsgeräten und der Operator-Station und eine dritte konfigurierte Anzahl der Prozessobjekte repräsentiert die Belastung im Hinblick auf die Kommunikation zwischen den realen und virtuellen Automatisierungsgeräten.

Mittels einer weiteren dieser Systemfunktionen - im Folgenden als erste Systemfunktion (Processing) bezeichnet - wird durch die Verarbeitung der ersten konfigurierten Anzahl der Prozessobjekte, welche zur Steuerung des technischen Prozesses auf den jeweiligen Automatisierungsgeräten und virtuellen Automatisierungsgeräten vorgesehen sind, eine Rechenlast auf den Geräten erzeugt. Diese Prozessobjekte werden z. B. mit APL-typischen (Advanced Process Library) Rechenoperationen verarbeitet.

Mittels einer weiteren dieser Systemfunktion - im Folgenden als zweite Systemfunktion (Kommunikation zwischen Automatisierungsgerät und Operator-Station; AS-OS-Kommunikation) bezeichnet - wird auf den jeweiligen Automatisierungsgeräten und jeweiligen virtuellen Automatisierungsgeräten durch die Verarbeitung der zweiten konfigurierten Anzahl der Prozessobjekte eine Rechenlast erzeugt, die für eine Bedienung und Beobachtung des jeweiligen Gerätes durch die Operator-Station relevant ist. Die Verarbeitung dieser Prozessobjekte ist somit zur Erzeugung der Kommunikationslast zwischen dem jeweiligen Gerät und der Operator-Station von Bedeutung.

Eine weitere Systemfunktion - im Folgenden als dritte Systemfunktion (Kommunikation zwischen den Automatisierungsgeräten) bezeichnet - verarbeitet die dritte konfigurierte Anzahl der Prozessobjekte. Dadurch wird auf den jeweiligen Geräten eine Rechenlast erzeugt, die aufgrund der Kommunikation bzw. des Datenaustausches zwischen den Geräten (zwischen den realen Automatisierungsgeräten, den realen und virtuellen Automatisierungsgeräten sowie zwischen realen und virtuellen Automatisierungsgeräten) bewerkstelligt wird. Diese Systemfunktion ermöglicht somit eine definierte Anzahl von Prozessobjekten von einem definierten Gerät zu laden und umgekehrt auch in dieses Gerät zu übertragen (in dem Zyklus in dem das Prozessobjekt auch verarbeitet wird). Beispielsweise kann dadurch während des Betriebs der Automatisierungseinrichtung zwischen den Geräten eine steuerungs- bzw. geräteübergreifende CFC Plan-Verschaltung verwirklicht werden.

Aufgrund dessen, dass die Geräte (Automatisierungsgeräte und virtuelle Automatisierungsgeräte) zur Lösung verschiedener (Teil-)Automatisierungsaufgaben vorgesehen sind, sind die in den Automatisierungsgeräten und virtuellen Automatisierungsgeräten hinterlegten, konfigurierten Prozessobjekte verschieden. Beispielweise sind an ein reales Automatisierungsgerät Sensoren und Aktuatoren zur Temperaturüberwachung eines Heizkessels angeschlossen, ein weiteres Automatisierungsgerät oder ein virtuelles Automatisierungsgerät überwacht mit weiteren geeigneten realen oder virtuellen Automatisierungskomponenten die Drehzahl eines Motors.

Wie erläutert, werden mittels eines Engineering-Systems und der Monitoring und Control-Systemfunktion die Prozessobjekte konfiguriert sowie ggf. parametriert und ferner mittels dieser Monitoring und Control-Systemfunktion die anderen Systemfunktionen im Hinblick auf eine Auslastung des jeweiligen Automatisierungsgerätes und des jeweiligen Simulations-Automatisierungsgerätes überwacht. Dabei kann ein Operator durch geeignete Eingaben an der Operator-Station die Prozessobjekte der ersten, zweiten und dritten Systemfunktion während des Betriebs der Automatisierungseinrichtung online parametrieren und ändern. Beispielsweise können die erste, zweite und dritte Anzahl der Prozessobjekte auf dem jeweiligen realen und virtuellen Automatisierungsgerät eingestellt oder geändert werden. Ferner können die Parameter der Prozessobjekte der Operator-Station übermittelt und auf dieser visualisiert werden, wobei anhand dieser Anzeige die jeweilige Auslastung der realen und virtuellen Automatisierungsgeräte erkannt und beurteilt werden kann. Beispielsweise werden die Sende- und/oder Empfangs-Puffer der Automatisierungsgeräte für die Kommunikation zwischen den Automatisierungsgeräten und der Operator-Station (AS-OS-Kommunikation) und/oder die aktuelle Reservezeit eines zyklischen Operations-Bausteins (Zykluszeitüberwachung) oder sonstige relevante Ereignisse eines weiteren Operation-Bausteins (Ereignisüberwachungs-Bausteins) auf der Operator-Station angezeigt. Mittels derartiger Ausgaben bzw. Anzeigen wird eine mögliche Ursache für eine zu hohe, eine Echtzeitverletzung verursachende Auslastung erkannt (Sende- und/oder Empfangs-Puffer voll), wodurch der Nachweis erbracht wird, dass eine Verteilung von einer oder mehreren virtuellen Automatisierungsgeräten auf einen anderen Server zur Entlastung erfolgen muss. Beispielsweise kann das virtuelle Automatisierungsgerät, die am frühesten eine Echtzeitverletzung aufweist, auf einem anderen Server ausgelagert und dort ausgeführt werden.

In einer Ausgestaltung der Erfindung ist vorgesehen, dass für den Fall, dass mittels der Monitoring und Control-Systemfunktion auf dem mindestens einen realen Automatisierungsgerät erkannt wird, dass die Auslastung einen Schwellwert erreicht oder überschreitet, mehrere Prozessobjekte des realen Automatisierungsgerätes zur Verarbeitung auf ein weiteres reales Automatisierungsgerät ausgelagert werden. Dadurch wird das mindestens eine reale Automatisierungsgerät entlastet und das Echtzeitverhalten sichergestellt.

Anhand der Zeichnung, in der ein Ausführungsbeispiel der Erfindung veranschaulicht ist, werden im Folgenden die Erfindung, deren Ausgestaltungen sowie Vorteile näher erläutert.

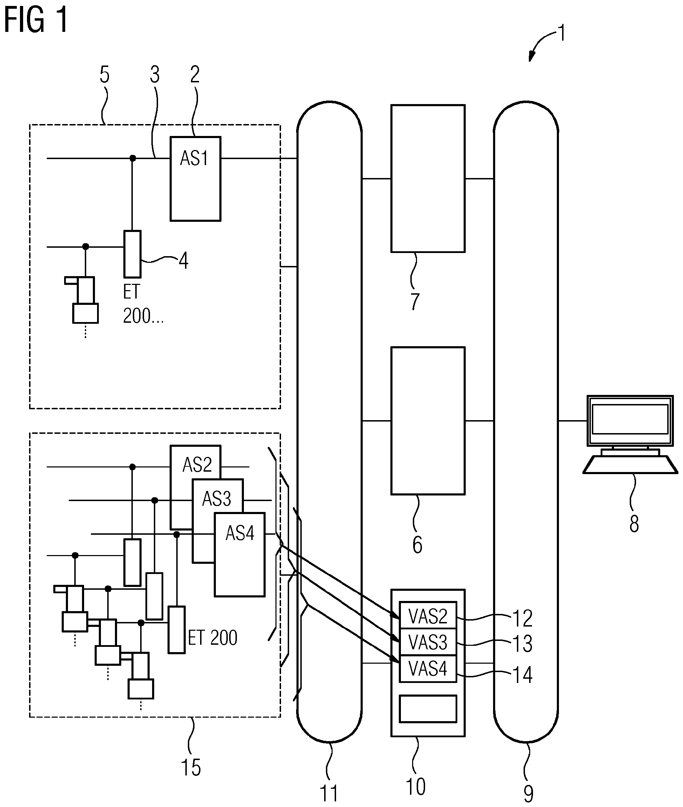

Es zeigen in einer vereinfachten Form
- Figur 1 bis 3: Automatisierungseinrichtungen.

Die in den Figuren 1 bis 3 dargestellten gleichen Teile sind mit gleichen Bezugszeichen versehen.

In Figur 1 ist mit 1 eine Automatisierungseinrichtung bezeichnet, die ein reales Automatisierungsgerät 2 aufweist, welches über einen Feldbus 3 mit einer dezentralen Peripherie 4 verbunden ist. Diese dezentrale Peripherie 4 ist mit einer Interface-Baugruppe und mit einer Vielzahl von Prozesseingabe- und Prozessausgabe-Baugruppen versehen, wobei an die jeweiligen Prozesseingabe-Baugruppen Sensoren und an die jeweiligen Prozessausgabe-Baugruppen Aktuatoren angeschlossen sind. Im vorliegenden Beispiel ist der Einfachheit halber lediglich eine reale Konfiguration 5 von realen Automatisierungskomponenten (Automatisierungsgerät 2, dezentrale Peripherie 4, ...) dargestellt. Gewöhnlich weist eine derartige Automatisierungseinrichtung eine Vielzahl solcher Automatisierungskomponenten zur Steuerung eines technischen Prozesses bzw. zur Lösung einer Automatisierungsaufgabe auf. Die Automatisierungseinrichtung 1 umfasst ferner ein Engineering-System 6 zum Projektieren, Konfigurieren und Parametrieren der Automatisierungseinrichtung 1 sowie eine Operator-Station 7, welche einem Operator eine komfortable und sichere Prozessbeobachtung und Prozessführung ermöglicht; der Operator kann bei Bedarf in den Prozessablauf steuernd eingreifen, was bedeutet, dass der Operator den durch die Automatisierungseinrichtung 1 zu steuernden technischen Prozess bedienen und beobachten kann. Der Operator kann mittels eines Clients 8, der gewöhnlich Bestandteil der Operator-Station 7 und/oder des Engineering-Systems 6 ist, über einen Terminal-Bus 9 auf die Projektierungs-Software des Engineering-Systems 6 und/oder auf die Bedien- und Beobachtungs-Software der Operator-Station 7 lesend und/oder der schreibend zugreifen. Der Client 8 repräsentiert daher im vorliegenden Beispiel sowohl einen OS (Operator Station)-Client als auch einen ES (Engineering-System)-Client. Das Engineering-System 6, die Operator-Station 7, ein Server 10 und das Automatisierungsgerät 2 sind an einen weiteren Bus, einen so genannten Anlagenbus 11, angeschlossen. Der Server 10 repräsentiert einen Simulations-Server, auf welchem virtuelle Automatisierungsgeräte 12, 13, 14 hinterlegt sind. Diese virtuellen Automatisierungsgeräte 12 bis 14 repräsentieren reale Automatisierungsgeräte und sind softwaretechnisch verwirklicht. Mit anderen Worten: Die Funktions- und Wirkungsweise realer Automatisierungsgeräte werden mittels der virtuellen Automatisierungsgeräte 12 bis 14 nachgebildet, wobei darüber hinaus der Server virtuelle dezentrale Peripherien sowie Sensoren und Aktuatoren nachbildet, welche mit den Simulations-Automatisierungsgeräten 12 bis 14 in Wirkverbindung stehen, was in der Zeichnung als virtuelle Konfiguration 15 bezeichnet ist. Aufgrund dessen, dass die Automatisierungseinrichtung 1 sowohl mit realen als auch mit virtuellen Automatisierungskomponenten versehen ist, stellt diese Automatisierungseinrichtung 1 eine Mischkonfiguration dar, die im Rahmen einer Inbetriebnahme oder im Rahmen einer Anlagenerweiterung bzw. Erweiterung der Automatisierungseinrichtung den Echtzeitanforderungen genügen muss.

Um diesen Anforderungen, insbesondere im Rahmen einer Inbetriebnahme der Automatisierungseinrichtung, zu genügen, weist jede der realen und virtuellen Automatisierungsgeräte 2, 12 bis 14 mehrere Systemfunktionen auf. Mittels einer als Monitoring und Control-Systemfunktion bezeichneten Systemfunktion und mittels des Engineering-Systems 6 sind Prozessobjekte konfigurierbar sowie parametrierbar, wobei ferner mittels dieser Monitoring und Control-Systemfunktion während des Steuerbetriebs die anderen Systemfunktionen im Hinblick auf eine Auslastung des jeweiligen Automatisierungsgerätes und des jeweiligen virtuellen Automatisierungsgerätes überwacht werden. Die Prozessobjekte werden während einer Engineering-Phase gemäß der zu lösenden Automatisierungsaufgabe sowie zu lösende, simulierte Automatisierungsaufgabe bestimmt, wobei die zu lösende Automatisierungsaufgabe gewöhnlich anhand von Plänen, Ausschreibungen, etc. vorgegeben ist.

Eine erste Anzahl dieser Prozessobjekte sind für die Prozesssteuerung konfiguriert, wobei diese Prozessobjekte auf dem realen Automatisierungsgerät 2 und den virtuellen Automatisierungsgeräten 12 bis 14 hinterlegt werden. Jedes dieser Automatisierungsgeräte 2, 12 bis 14 löst einen Teil der Automatisierungsaufgabe bzw. simulierten Automatisierungsaufgabe, wodurch die auf den verschiedenen Automatisierungsgeräten 2, 12 bis 14 konfigurierten und hinterlegten Prozessobjekte verschieden sind. Eine zweite Anzahl der Prozessobjekte sind konfiguriert für eine Kommunikation zwischen dem jeweiligen Automatisierungsgerät 2, 12 bis 14 und der Operator-Station 7, 8 und eine dritte Anzahl der Prozessobjekte sind für eine Kommunikation zwischen den Automatisierungsgeräten 2, 12 bis 14 konfiguriert.

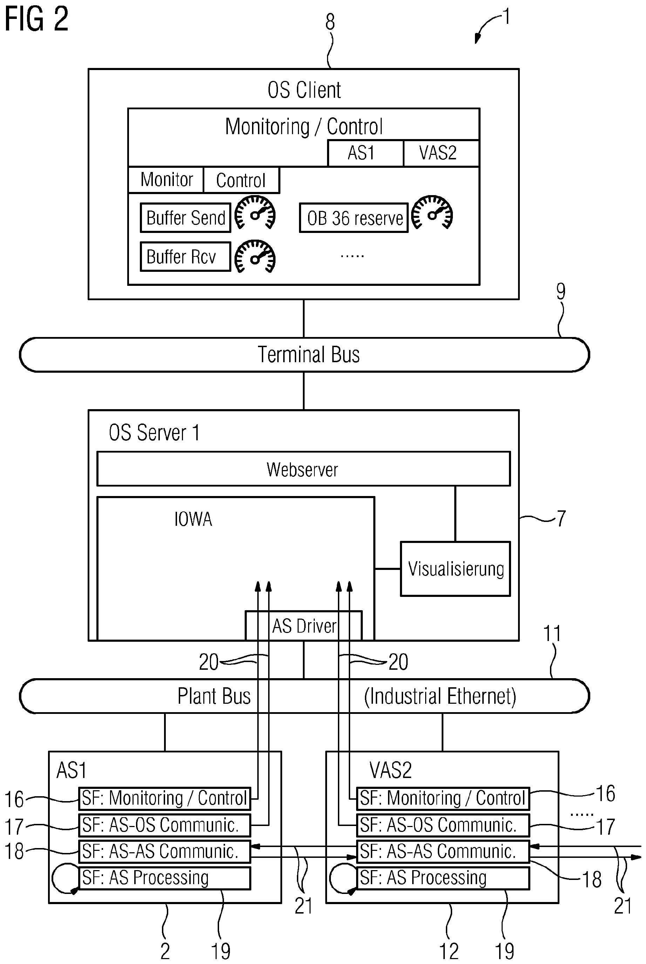

In Figur 2 sind Systemfunktionen 16 bis 19 für das reale Automatisierungsgerät 2 und für das virtuelle Automatisierungsgerät 12 der Automatisierungseinrichtung 1 dargestellt, wobei die Systemfunktion 16 als Monitoring und Control-Systemfunktion ausgebildet ist und wobei angenommen wird, dass die virtuellen Automatisierungsgeräte 12 bis 14 auf dem Server 10 angelegt und hinterlegt sind. Mit Pfeilen 20 ist in Figur 2 die Kommunikation der jeweiligen Automatisierungsgeräte 2, 12 mit der OS-Station 7, 9 und mit Pfeilen 21 die Kommunikation zwischen den Automatisierungsgeräten 2, 12, ... angedeutet.

Mittels der Systemfunktion 17 (Kommunikation zwischen Automatisierungsgerät und Operator-Station; AS-OS-Kommunikation) wird auf den jeweiligen Automatisierungsgeräten 2, 12 bis 14 durch Verarbeitung der (AS-OS-Kommunikations-)Prozessobjekte eine Rechenlast erzeugt, die für eine Bedienung und Beobachtung des jeweiligen Gerätes 2, 12 bis 14 durch die Operator-Station relevant ist.

Mittels der Systemfunktion 18 (Kommunikation zwischen den Automatisierungsgeräten 2, 12 bis 14; AS-AS-Kommunikation) wird auf dem jeweiligen Gerät AS-AS-Kommunikations-Prozessobjekte verarbeitet. Dadurch wird auf dem jeweiligen Gerät 2, 12 bis 14 eine Rechenlast erzeugt, die aufgrund der Kommunikation bzw. des Datenaustausches zwischen den Geräten bewerkstelligt wird.

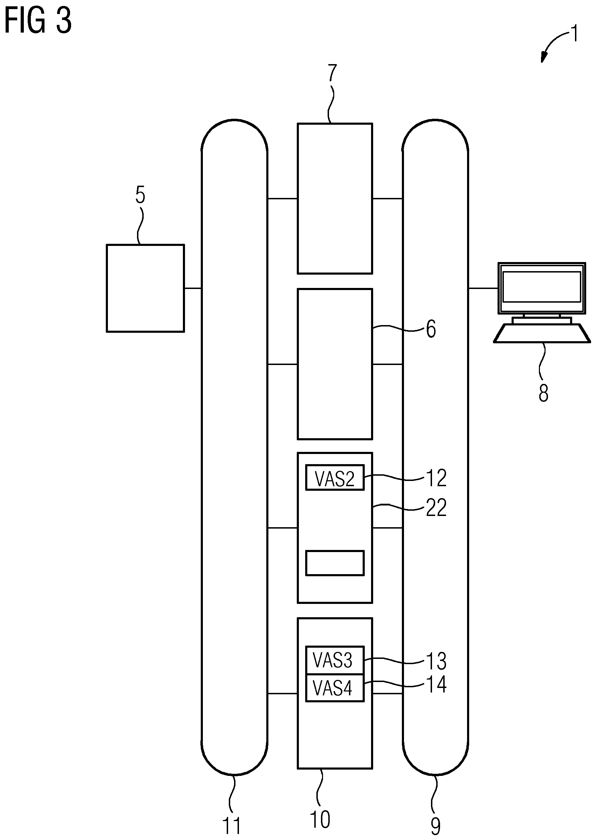

Mittels der Systemfunktionen 19 (Processing) wird durch die Verarbeitung der Prozessobjekte, welche zur Steuerung des technischen (Teil)Prozesses auf dem jeweiligen Automatisierungsgerät 2, 12 bis 14 vorgesehen sind, eine Rechenlast auf dem Gerät erzeugt. Ferner werden mittels der OS-Clients 8 die Auslastungen bzw. Belastungen der Systemfunktionen 17 bis 19 dargestellt, welche durch die Systemfunktion 16 (Monitoring und Control) überwacht werden. Im vorliegenden Ausführungsbeispiel werden auf dem OS-Client 8 die Auslastungen der jeweiligen Systemfunktionen 17 (AS-OS-Kommunikation) des realen Automatisierungsgerätes 2 und des virtuellen Automatisierungsgerätes 12 dargestellt. Selbstverständlich können auch die Belastungen der weiteren Systemfunktionen 18, 19 auf dem OS-Client 8 angezeigt werden. Für den Fall, dass die Systemfunktion 16 des virtuellen Automatisierungsgerätes 12 erkennt, dass die Auslastung bzw. Belastung der Systemfunktion 17 einen Schwellwert erreicht oder überschreitet, wodurch der vorgegebene Verarbeitungszyklus der Automatisierungseinrichtung 1 überschritten wird bzw. das Echtzeitverhalten der Automatisierungseinrichtung 1 nicht mehr gewährleistet ist, wird das virtuelle Automatisierungsgerät 12 auf einen weiteren Server 22 (Figur 3) ausgelagert. Selbstverständlich wird das virtuelle Automatisierungsgerät 12 auch dann auf den weiteren Server 22 ausgelagert, falls die Systemfunktion 16 erkennt, dass die Auslastung bzw. Belastung der Systemfunktion 18 oder 19 einen Schwellwert erreicht oder überschreitet; denn auch bei einer derartigen Überlastung ist das Echtzeitverhalten der Automatisierungseinrichtung 1 nicht mehr gewährleistet.

Die Auslagerung eines virtuellen Automatisierungsgerätes 12 bis 14 kann mittels der Systemfunktion 16 des überlasteten, virtuellen Automatisierungsgerätes 12 bis 14 erfolgen. Die Systemfunktion 16 lagert das überlastete Automatisierungsgerät 12 bis 16 automatisch aus, wobei dazu diese Systemfunktion 16 und der Server 22 mit einer geeigneten "Auslagerung"-Software versehen sind. Selbstverständlich kann die Auslagerung auch durch das Engineering-System 6 erfolgen, wobei die Systemfunktion 16 dem Engineering-System 6 eine Überlastung anzeigt, aufgrund dessen das Engineering-System 6 die Auslagerung auf den Server 22 bewerkstelligt.

Mittels der beschriebenen Maßnahmen wird ein "Einmessen" der virtuellen Automatisierungsgeräte ermöglicht, wobei folgende Vorgehensweise bevorzugt wird:
a) die virtuellen Automatisierungsgeräte werden zunächst auf einem Server "platziert",
b) durch die Ausführung der jeweiligen Monitoring und Control-Systemfunktion werden die Ausführung der jeweiligen anderen Systemfunktionen auf dem jeweiligen virtuellen Automatisierungsgerät überwacht,
c) bei einer Zykluszeitverletzung oder bei einer zu geringen Zykluszeitreserve eines der virtuellen Automatisierungsgeräte wird dieses auf einen weiteren Server ausgelagert,
d) die Schritte b) und c) werden wiederholt, bis die Echtzeitfähigkeit der Automatisierungseinrichtung erreicht ist.
Ist die Echtzeitfähigkeit der Automatisierungseinrichtung erreicht, können die virtuellen Automatisierungsgeräte durch reale Automatisierungsgeräte ersetzt werden.

## Patentansprüche

1. Verfahren zum Betreiben einer Automatisierungseinrichtung (1), die mindestens ein reales Automatisierungsgerät (2) zum Steuern eines technischen Prozesses, eine Operator-Station (7) zum Bedienen und Beobachten des zu steuernden technischen Prozesses, ein Engineering-System (6) und virtuelle Automatisierungsgeräte (12 bis 14) umfasst, die jeweils Funktionen eines realen Automatisierungsgerätes nachbilden und die auf einem Server (10) hinterlegt sind, wobei das Automatisierungsgerät (2) und die virtuellen Automatisierungsgeräte (12 bis 14) jeweils Systemfunktionen (16 bis 19) umfassen,**dadurch gekennzeichnet, dass**
- mittels des Engineering-Systems (6) und mittels einer dieser Systemfunktionen (16) Prozessobjekte für die anderen Systemfunktionen (17-19) konfiguriert werden und mittels dieser einen Systemfunktion (16) die anderen Systemfunktionen (17 bis 19) im Hinblick auf eine Auslastung des jeweiligen Automatisierungsgerätes (2, 12 bis 14) überwacht werden,
- mittels der anderen Systemfunktionen (17 bis 19)
- eine erste konfigurierte Anzahl der Prozessobjekte auf dem jeweiligen Automatisierungsgerät (2, 12 bis 14) verarbeitet werden,
- eine zweite konfigurierte Anzahl der Prozessobjekte zwischen dem jeweiligen Automatisierungsgerät (2, 12 bis 14) und der Operator-Station (7, 8)ausgetauscht werden,
- eine dritte konfigurierte Anzahl der Prozessobjekte zwischen dem jeweiligen Automatisierungsgerät (2, 12 bis 14) und den weiteren Automatisierungsgeräten (2, 12 bis 14) ausgetauscht werden,
- für den Fall, dass mittels der einen Systemfunktion (16) auf einem der virtuellen Automatisierungsgeräte (12 bis 14) erkannt wird, dass die Auslastung der jeweiligen anderen Systemfunktion (17 bis 19) einen Schwellwert erreicht oder überschreitet, dieses virtuelle Automatisierungsgerät auf einen weiteren Server (22) ausgelagert wird.

2. Verfahren nach Anspruch 1, **dadurch gekennzeichnet, dass** für den Fall, dass mittels der einen Systemfunktion (16) auf dem mindestens einen realen Automatisierungsgerät (2) erkannt wird, dass die Auslastung einen Schwellwert erreicht oder überschreitet, mehrere Prozessobjekte des mindestens einen realen Automatisierungsgerätes (2) zur Verarbeitung auf ein weiteres reales Automatisierungsgerät ausgelagert werden.

3. Automatisierungseinrichtung mit mindestens einem realen Automatisierungsgerät (2) zum Steuern eines technischen Prozesses, mit einer Operator-Station (7, 8) zum Bedienen und Beobachten des zu steuernden technischen Prozesses, mit einem Engineering-System (6) und mit virtuellen Automatisierungsgeräten (12 bis 14), die jeweils Funktionen eines realen Automatisierungsgerätes nachbilden und die auf einem Server (10) hinterlegt sind, wobei das reale Automatisierungsgerät (2) und die virtuellen Automatisierungsgeräte (12 bis 14) jeweils Systemfunktionen (16 bis 19) umfassen, **dadurch gekennzeichnet, dass**
- das Engineering-System (6) und eine dieser Systemfunktion dazu ausgebildet sind, Prozessobjekte zu konfigurieren und die eine Systemfunktion (16) ferner dazu ausgebildet ist, die anderen Systemfunktionen (17 bis 19) im Hinblick auf eine Auslastung des jeweiligen Automatisierungsgerätes (2, 12 bis 14) zu überwachen,
- die anderen Systemfunktionen (17 bis 19) dazu ausgebildet sind,
- eine erste konfigurierte Anzahl der Prozessobjekte auf dem jeweiligen Automatisierungsgerät (2, 12 bis 14) zu verarbeiten,
- eine zweite konfigurierte Anzahl der Prozessobjekte zwischen dem jeweiligen Automatisierungsgerät (2, 12 bis 14) und der Operator-Station (7, 8) auszutauschen,
- eine dritte konfigurierte Anzahl der Prozessobjekte zwischen dem jeweiligen Automatisierungsgerät (2, 12 bis 14) und den weiteren Automatisierungsgeräten (2, 12 bis 14) auszutauschen,
- die Automatisierungseinrichtung (1) dazu ausgebildet ist, für den Fall, dass mittels der einen Systemfunktion (16) auf einem der virtuellen Automatisierungsgeräte (12 bis 14) erkannt wird, dass die Auslastung der jeweiligen anderen Systemfunktion (17 bis 19) einen Schwellwert erreicht oder überschreitet, dieses virtuelle Automatisierungsgerät (12 bis 14) auf einen weiteren Server (22) auszulagern.

4. Automatisierungseinrichtung nach Anspruch 3, **dadurch gekennzeichnet, dass** die Automatisierungseinrichtung (1) ferner dazu ausgebildet ist, für den Fall, dass mittels der einen Systemfunktion (16) auf dem mindestens einen realen Automatisierungsgerät (2) erkannt wird, dass die Auslastung einen Schwellwert erreicht oder überschreitet, mehrere Prozessobjekte des mindestens einen realen Automatisierungsgerätes (2) zur Verarbeitung auf ein weiteres reales Automatisierungsgerät auszulagern.

## Claims

1. Method for operating an automation device (1) comprising at least one real automation unit (2) for controlling a technical process, an operator station (7) for operating and observing the technical process to be controlled, an engineering system (6) and virtual automation units (12 to 14) each of which simulates functions of a real automation unit and is stored on a server (10), wherein the automation unit (2) and the virtual automation units (12 to 14) each comprise system functions (16 to 19), **characterised in that**
- the engineering system (6) and one of these system functions (16) are used to configure process objects for the other system functions (17-19) and these are used to monitor a system function (16) of the other system functions (17 to 19) with respect to utilisation of the respective automation unit (2, 12 to 14),
- the other system functions (17 to 19) are used
- to process a first configured number of the process objects on the respective automation unit (2, 12 to 14),
- to exchange a second configured number of the process objects between the respective automation unit (2, 12 to 14) and the operator station (7, 8),
- to exchange a third configured number of the process objects between the respective automation unit (2, 12 to 14) and the further automation units (2, 12 to 14),
- in the event of the one system function (16) on one of the virtual automation units (12 to 14) identifying that the utilisation of the respective other system function (17 to 19) has reached or exceeded a threshold value, this virtual automation unit is transferred to a further server (22).

2. Method according to claim 1, **characterised in that** in the event of the one system function of the one system function (16) on the at least one real automation unit (2) identifying that the utilisation has reached or exceeded a threshold value, a plurality of process objects of the at least one real automation unit (2) is transferred to a further real automation unit for processing.

3. Automation device with at least one real automation unit (2) for controlling a technical process, with an operator station (7, 8) for operating and observing the technical process to be controlled, with an engineering system (6) and with virtual automation units (12 to 14) each of which simulates functions of a real automation unit and is stored on a server (10), wherein the real automation unit (2) and the virtual automation units (12 to 14) each comprise system functions (16 to 19), **characterised in that**
- the engineering system (6) and one of these system functions are embodied to configure process objects and the one system function (16) is further embodied to monitor the other system functions (17 to 19) with respect to utilisation of the respective automation unit (2, 12 to 14),
- the other system functions (17 to 19) are embodied
- to process a first configured number of the process objects on the respective automation unit (2, 12 to 14),
- to exchange a second configured number of the process objects between the respective automation unit (2, 12 to 14) and the operator station (7, 8),
- to exchange a third configured number of the process objects between the respective automation unit (2, 12 to 14) and the further automation units (2, 12 to 14),
- the automation device (1) is embodied, in the event that it is identified by means of the one system function (16) on one of the virtual automation units (12 to 14) that the utilisation of the respective other system function (17 to 19) has reached or exceeded a threshold value, to transfer this virtual automation unit (12 to 14) to a further server (22) .

4. Automation device according to claim 3, **characterised in that** the automation device (1) is further embodied, in the event that it is identified by means of the one system function (16) on the at least one real automation unit (2) that the utilisation has reached or exceeded a threshold value, to transfer a plurality of process objects of the at least one real automation unit (2) to a further real automation unit for processing.

## Revendications

1. Procédé pour faire fonctionner un dispositif (1) d'automatisation, qui comprend au moins un appareil (2) réel d'automatisation pour la commande d'un processus technique, un poste (7) d'opérateur pour la conduite et l'observation du processus technique à commander, un système (6) d'ingénierie et des appareils (12 à 14) virtuels d'automatisation, qui reproduisent chacun des fonctions d'un appareil réel d'automatisation et qui sont mis en mémoire sur un serveur (10), l'appareil (2) d'automatisation et les appareils (12 à 14) virtuels d'automatisation comprenant chacun des fonctions (16 à 19) de système, **caractérisé en ce que**
- au moyen du système (6) d'ingénierie et au moyen de l'une de ces fonctions (16) de système, on configure des objets de processus pour les autres fonctions (17 à 19) de système et au moyen de cette fonction (16) de système, on contrôle les autres fonctions (17 à 19) de système en ce qui concerne une utilisation de l'appareil (2, 12 à 14) respectif d'automatisation,
- au moyen des autres fonctions (17 à 19) de système
- on traite un premier nombre configuré des objets de processus sur l'appareil (2, 12 à 14) respectif d'automatisation,
- on échange un deuxième nombre configuré des objets de processus entre l'appareil (2, 12 à 14) respectif d'automatisation et le poste (7, 8) d'opérateur,
- on échange un troisième nombre configuré des objets de processus entre l'appareil (2, 12 à 14) respectif d'automatisation et les autres appareils (2, 12 à 14) d'automatisation,
- dans le cas où, au moyen de la une fonction (16) de système, on détecte, sur l'un des appareils (12 à 14) virtuels d'automatisation, que l'utilisation de l'autre fonction (17 à 19) de système respective atteint une valeur de seuil ou la dépasse, on transfère cet appareil virtuel d'automatisation sur un autre serveur (22).

2. Procédé suivant la revendication 1, **caractérisé en ce que**, dans le cas où, au moyen de la une fonction (16) de système, on détecte, sur le au moins un appareil (2) réel d'automatisation, que l'utilisation atteint une valeur de seuil ou la dépasse, on transfère plusieurs objets de processus du au moins un appareil (2) réel d'automatisation pour le traitement à un autre appareil réel d'automatisation.

3. Dispositif d'automatisation comprenant au moins un appareil (2) réel d'automatisation pour commander un processus technique, comprenant un poste (7, 8) d'opérateur pour la conduite et l'observation du processus technique à commander, comprenant un système (6) d'ingénierie et comprenant des appareils (12 à 14) virtuels d'automatisation, qui reproduisent chacun des fonctions d'un appareil réel d'automatisation et qui sont mis en mémoire sur un serveur (10), l'appareil (2) réel d'automatisation et les appareils (12 à 14) virtuels d'automatisation comprenant chacun des fonctions (16 à 19) de système, **caractérisé en ce que**
- le système (6) d'ingénierie et l'une de ces fonctions de système sont constitués de manière à configurer des objets de processus et la une fonction (16) de système est constituée, en outre, de manière à contrôler les autres fonctions (17 à 19) de système en ce qui concerne une utilisation de l'appareil (2, 12 à 14) respectif d'automatisation,
- les autres fonctions (17 à 19) de système sont constituées
- de manière à traiter un premier nombre configuré des objets de processus sur l'appareil (2, 12 à 14) respectif d'automatisation,
- de manière à échanger un deuxième nombre configuré des objets de processus entre l'appareil (2, 12 à 14) respectif d'automatisation et le poste (7, 8) d'opérateur,
- de manière à échanger un troisième nombre configuré des objets de processus entre l'appareil (2, 12 à 14) respectif d'automatisation et les autres appareils (2, 12 à 14) d'automatisation,
- le dispositif (1) d'automatisation est constitué de manière, pour le cas où, au moyen de la une fonction (16) de système, on détecte, sur l'un des appareils (12 à 14) virtuels d'automatisation, que l'utilisation de l'autre fonction (17 à 19) de système respective atteint une valeur de seuil ou la dépasse, à transférer cet appareil (12 à 14) virtuel d'automatisation sur un autre serveur (22).

4. Dispositif d'automatisation suivant la revendication 3, **caractérisé en ce que** le dispositif (1) d'automatisation est constitué, en outre, de manière, pour le cas où, au moyen de la une fonction (16) de système, on détecte, sur le au moins un appareil (2) réel d'automatisation, que l'utilisation atteint une valeur de seuil ou la dépasse, à transférer plusieurs objets de processus du au moins un appareil (2) réel d'automatisation pour le traitement sur un autre appareil réel d'automatisation.
